(19)

**Europäisches Patentamt**
**European Patent Office**
**Office européen des brevets**

(11) **EP 0 452 700 B1**

(12) **EUROPÄISCHE PATENTSCHRIFT**

(45) Veröffentlichungstag und Bekanntmachung des Hinweises auf die Patenterteilung:
**01.05.1996 Patentblatt 1996/18**

(51) Int Cl.6: **H04N 1/46**

(21) Anmeldenummer: **91104525.0**

(22) Anmeldetag: **22.03.1991**

(54) **Verfahren und Vorrichtung zur Bestimmung von Passerdifferenzen an Druckbildstellen eines Mehrfarbenoffsetdruckes**

Method and device for determining compass differences of printing image positions of a multicolour offset printing

Procédé et appareil pour déterminer les différences de repère entre les positions d'image d'impression offset en couleurs

(84) Benannte Vertragsstaaten:
**AT BE CH DE ES FR GB IT LI NL SE**

(30) Priorität: **20.04.1990 DE 4012608**

(43) Veröffentlichungstag der Anmeldung:
**23.10.1991 Patentblatt 1991/43**

(73) Patentinhaber: **MAN Roland Druckmaschinen AG**
**D-63012 Offenbach (DE)**

(72) Erfinder:
- **Steiner, Gerd**
  **W-6056 Heusenstamm (DE)**
- **Weniger, Rudi, Dr.**
  **W-6050 Offenbach/Main (DE)**
- **Braun, Rolf**
  **W-6050 Offenbach/Main (DE)**
- **Otterbach, Rainer**
  **W-5900 Siegen (DE)**
- **Schubert, Erhard**
  **W-5920 Bad Berleburg (DE)**
- **Hofmann, Ralf**
  **W-5900 Siegen (DE)**

(74) Vertreter: **Marek, Joachim, Dipl.-Ing.**
**c/o MAN Roland Druckmaschinen AG**
**Patentabteilung/FTB S,**
**Postfach 10 12 64**
**D-63012 Offenbach (DE)**

(56) Entgegenhaltungen:
**EP-A- 0 127 831**
**EP-A- 0 177 885**
**EP-A- 0 296 602**

EP 0 452 700 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft ein Verfahren zur Bestimmung von Passerdifferenzen nach Anspruch 1 und eine Vorrichtung zur Durchführung des Verfahrens nach Anspruch 10.

Beim mehrfarbigen Bogenoffsetdruck werden nacheinander in verschiedenen Druckwerken einzelne Teilbilder in den verschiedenen Druckfarben (z. 8. Yellow, Cyan, Magenta, Schwarz) übereinandergedruckt. Häufig werden zusätzlich noch Teilbilder bzw. Teilflächen in Sonder-, Schmuck- oder Hausfarben gedruckt (Verpackungsdruck, Druck hochwertiger Werbeprospekte). Die Qualität solcher Druckerzeugnisse hängt dabei stark von der Exaktheit des Übereinanderdrucks dieser Teilbilder ab. Im Idealzustand decken sich die einzelnen Teilbilder in ihren Sollpositionen auf dem Druckbogen. Abweichungen von diesem Idealzustand, d.h. nicht deckungsgleicher Zusammendruck machen sich als Passerdifferenzen bemerkbar und werden als Registerfehler bezeichnet.

Um den Registerfehler wertemäßig erfassen und gezielt beheben zu können, werden in den einzelnen Teilbildern Passmarken, Passzeichen bzw. Messelemente mitgedruckt, anhand derer sich die Passerdifferenzen der verschiedenen Teilbilder zueinander ermitteln lassen. Gedruckt werden diese in der Regel im druckbildfreien Bereich, beispielsweise in den Ecken des Druckbogens. Aus den Passerdifferenzen lassen sich dann die nötigen Verstellungen der zu einem bestimmten Teilbild gehörenden Druckplatte bzw. des Druckplattenzylinders ermitteln.

Kreuzförmige Passzeichen, sogenannte Passkreuze erlauben an und für sich lediglich rasches Feststellen, daß keine Passerdifferenz also keine Registerfehler vorliegen. Wertemäßige Passerdifferenzermittlung mit Messmikroskop oder ähnlichem ist entsprechend mühsam und zeitaufwendig.

Passerdifferenzbestimmung mittels dem FOGRA-Nonius-Messelement bzw. dem "Interferenz-Vernier" (siehe Deutscher Drucker, Heft Nr. 1, 1990, Seite w27-30) bringen zwar Komfort beim Ablesen und erhöhen ferner die Ablesegenauigkeit, benötigen aber bei vielen Teilbilddrucken relativ viel Raum im druckbildfreien Bereich.

Über die visuelle Bestimmung der Passerdifferenz hinaus sind automatisierte Meßgeräte bekannt, die mit speziell ausgebildeten Passmarken zusammenwirken und durch fotoelektrische Abtastung dieser Marken die Passerdifferenz ermitteln. Passmarken und entsprechende Abtastgeräte dieser Art sind z.B. auf der DE 3 709 858 Al bzw. der DE 3 719 766 Al bekannt. Nachteilig hierbei ist, daß solche speziellen Passmarken auf lange Sicht unflexibel und die entsprechenden Abtastgeräte zu einem anderen Zweck nicht verwendbar sind.

Den Einsatz der Videotechnik mit Bildverarbeitung zur Passerdifferenzbestimmung an Passkreuzen zeigen die Gegenstände der EP 0 177 885 A2 und der EP 0 221 472 A2. Die Passerdifferenzbestimmung erfolgt interaktiv und halbautomatisch, in dem die per Videokamera aufgenommmenen und auf einem Monitor vergrößert dargestellten Passkreuze von einer Bedienperson über eine Cursorsteuerung aktiviert werden. Ein Auswerterechner bestimmt dann aus den Bildkoordinaten die Passerdifferenz. Die Genauigkeit der Passerdifferenzbestimmung hängt aber hier genau wie bei einer Bestimmung mit Messlupe bzw. Messmikroskop von der Druckqualität der Passkreuze (Konturschärfe) ab. Geringe Passerdifferenzen können nur mit sehr feinen Passkreuzlinien sicher bestimmt werden, dementsprechend negativ wirkt sich die durch den Druck und die Papierrauheit bedingte, ausgefranste Struktur solch feiner Linien bei starker Vergrößerung aus.

Die Passerdifferenzbestimmung anhand extra mitgedruckter Passzeichen, Passmarken oder Messelementen hat gemeinsam den Nachteil, daß einmal zusätzlich Raum auf den Bedruckstoff benötigt wird, andererseits ist der Dekkungszustand der Teilbilder im Druckbild selbst für die Qualität des Druckerzeugnisses ausschlaggebend und nicht der der Passzeichen oder -marken. Der erfahrene Drucker überprüft daher den Passer nicht nur anhand mitgedruckter Passzeichen oder ähnlichem, sondern vor allem auch an mehreren bildwichtigen und die Passerdifferenzen besonders deutlich wiedergebenden Druckbild-Details.

Passerdifferenzen deutlich wiedergebende Druckbilddetails sind beispielsweise farbige Schriftzeichen, welche durch den Übereinanderdruck von wenigstens zwei Druckfarben auf einfarbigen bzw. unbedruckten Untergrund entstanden sind, ferner helle Schriftzeichen (z.B. unbedruckt) auf dunklem Untergrund, wiederum entstanden durch den Übereinanderdruck von wenigstens zwei Druckfarben (sogenannte Negativschrift), und überhaupt jegliche Konturen, die von mehreren Teilbildern gebildet werden (Haare, Uhrzeiger, Linien o.ä.).

Entsteht im Beispiel der Negativschrift ein Buchstabe als unbedruckter Bereich in einer durch den Übereinanderdruck von Magenta und Cyan entstandenen Umgebung (Hintergrund), so treten Passerdifferenzen des Cyanteilbildes gegenüber dem Magentateilbild als entsprechend feine Cyan- bzw. magentafarbene Farbsäume hervor. Besonders leicht sind Farbsäume mit ihren Ursachen in Passerdifferenzen bei langen und geradliniegen Konturen erkennbar. Der Grund hierfür liegt in der Noniussehschärfe des Auges sowie im Farbkontrast eines Farbsaumes.

Sollen die Passerdifferenzen nach obiger Art an mehreren wichtigen Stellen des Druckbildes beurteilt werden, so ist dies in mühsames, viel Erfahrung benötigendes aber wertemäßig ungenaues Verfahren. Mehrere Messungen sind aber nötig, um die Verteilung des Passers bzw. der Passerdifferenzen über den Druckbogen erfassen zu können und dementsprechend eine optimale Einstellung des Registers bzw. anderer sich auf den Passer des Druckes auswirkenden Maschineneinstellungen vorzunehmen.

Die EP 0 127 831 A2 beschreibt die Passerdifferenzbestimmung mittels einer Fernsehkamera und einer nachgeschalteten Rechnereinheit aus der Lage der verschiedenfarbigen Rasterpunkte zueinander bzw. im Vergleich mit deren Sollage. Die Rasterpunkte werden quasi wie Passzeichen verwendet, die bei optimaler Lage der Teilbilder zueinander definierte, und exakt vorgehbare Abstände zueinander einnehmen.

Nachteilig hierbei ist, daß die Sollage der Rasterpunkte in den Teilbildern zueinander bekannt sein müssen. Gemäß dem in oben genannter Schrift entnehmbaren eignet sich das Meßprinzip hauptsächlich zur Beurteilung und Bestimmung des Passerverhaltens der Teilbilder einer Bildstelle, wenn diese, wie vorgesehen an einer laufenden Druckbahn aufgenommen werden. Es sind so die gleichen Bildstellen aufeinander folgender Druckbilder in ihrem Passerverhalten beurteilbar.

Aufgabe der Erfindung ist es, ein Verfahren und eine Vorrichtung vorausstehend genannter Gattung so zu verbessern, daß eine Ermittlung von Passerdifferenzen an Konkturen aufweisenden kritischen Druckbildstellen des Druckbogens möglichst und weitgehend unabhängig von der Rasterpunktart, der Rasterpunktgröße und deren Verteilung ist.

Gelöst wird die Aufgabe durch die Merkmale von Anspruch 1 und von Anspruch 10. Weiterbildungen ergeben sich aus den Unteransprüchen in Verbindung mit der Beschreibung und den Zeichnungen.

Nachstehend wird die Erfindung an einem Ausführungsbeispiel näher erläutert. In der zugehörigen Zeichnung zeigt

| | |
|---|---|
| Figur 1a, b, c | eine Kontur am Beispiel einer Negativschrift |
| Figur 2a | eine Messvorrichtung nach der Erfindung |
| Figur 2b | den Aufbau der Farbvideokamera |
| Figur 3 | eine Verdeutlichung zur Farbauszugsrechnung |
| Figur 4a, b, c | Beispiele von Auszügen einiger Teilbilder |
| Figur 5 | die Bestimmung von Passerdifferenzen an einer Kontur |

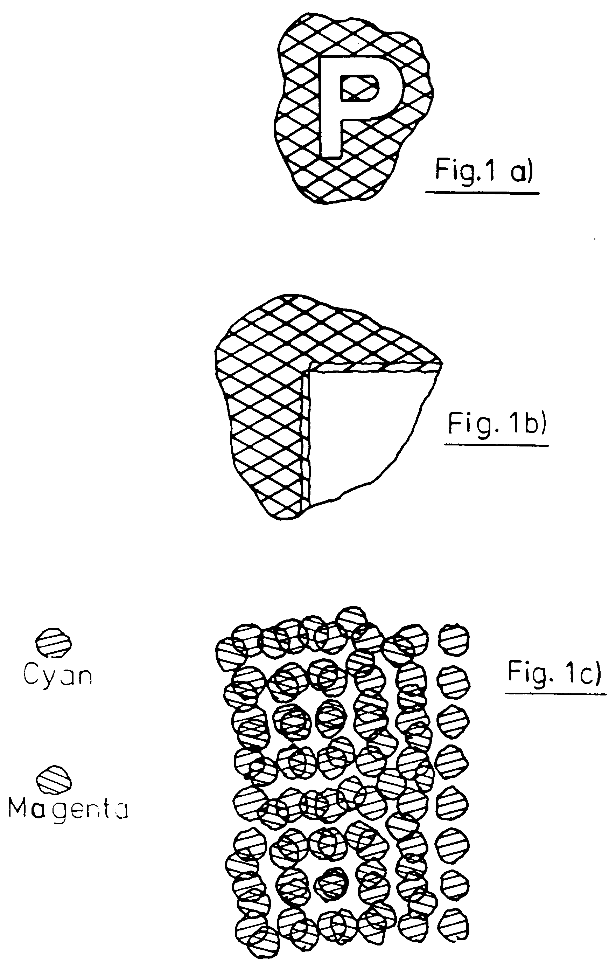

Ein Beispiel einer Kontur in einer Negativschrift zeigt Figur 1a. Der Buchstabe "P" bestehe hier der Einfachheit wegen als nichtbedruckter Bereich des Druckpapiers in einem Umfeld, das durch den Übereinanderdruck der Druckfarben Cyan und Magenta entstanden ist. Ebenfalls sei angenommen, daß die beiden Teilbilder in ungefähr gleichen Rasterpunktgrößen und annähernd den Solldichten oder Optimal-Färbung gedruckt sind. Dies ergibt ein Umfeld welches einen Blau-Violetton zeigt.

Figur 1b zeigt die linke obere Ecke des Buchstaben "P" noch einmal vergrößert. Wie angedeutet wurde das Magentateilbild nicht exakt lagegenau über das Cyanteilbild gedruckt. Es ist also eine Passerdifferenz in Form eines Farbsaumes erkennbar, dessen Farbeindruck von dem jeweils überstehenden Teilbild abhängt. Selbstverständlich können auch weitere Druckfarben beteiligt sein, die Beschränkung dieses Beispiels auf zwei Druckfarben dient, wie bereits erwähnt der Einfachheit.

Figur 1c zeigt eine Kontur der Bildstelle noch einmal vergrößert. (Bei einer Rasterweite von 60 Linien/cm etwa 120-fach). Deutlich ist die Rasterpunktstruktur der Teilbilder einzeln und im Übereinanderdruck zu erkennen. Die einzelnen Rasterpunkte ergaben dabei wie angedeutet entsprechend der Papierrauheit mehr oder weniger stark zerfranste Abdrucke. Ein solches Bild ergibt sich dem Betrachter, wenn er sich die Bildstelle durch ein Messmikroskop mit entsprechender Vergrößerung betrachtet.

Bereits dieses Beispiel nach Figur 1c macht deutlich, daß eine Passerdifferenzbestimmung an einer solchen Kontur zu einem recht unsicheren Ergebnis führt. Verkompliziert wird dieser Sachverhalt noch, wenn die Kontur durch Übereinanderdruck von mehr als zwei Druckfarben mit verschiedenen Rasterpunktgrößen zustande gekommen ist und ebenfalls der Bereich des Buchstabens selbst ein- oder mehrfarbig bedruckt ist, z.B. mit geringer Rasterpunktgröße. Eine stärkere Vergrößerung bringt keine besseren Ergebnisse, da durch den vielfachen Übereinanderdruck sowie die stark zerrissene Rasterpunktstruktur die verschiedensten Farbeindrücke entstehen und somit die Konturen der Einzelbilder nicht mehr erkennbar sind.

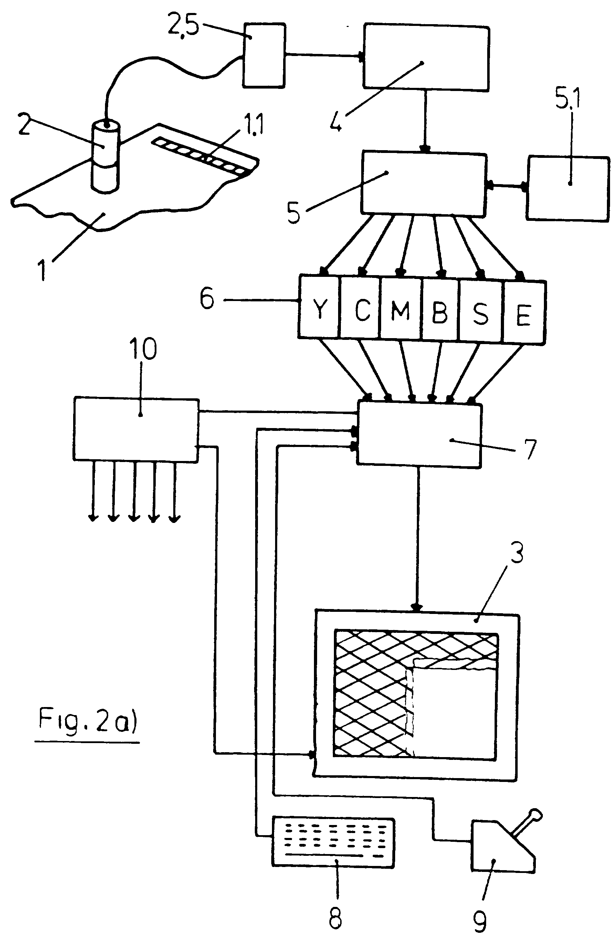

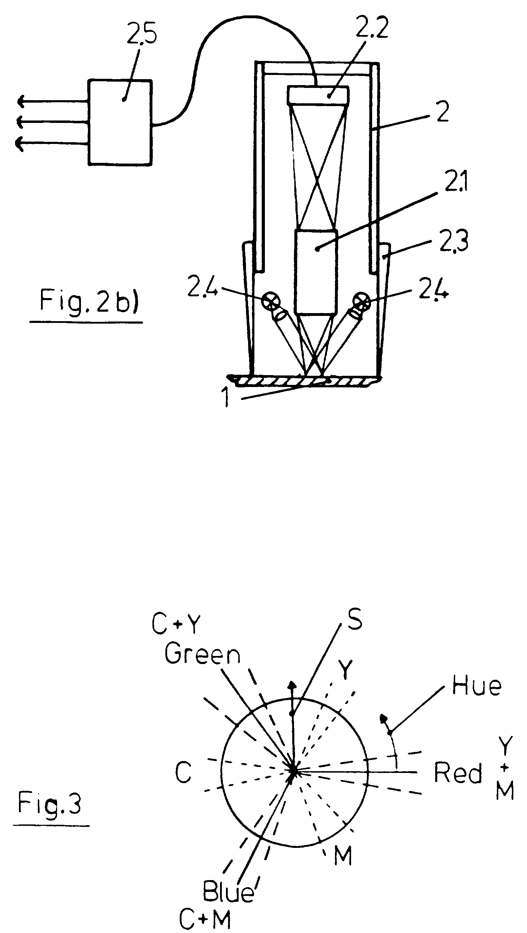

Figur 2a zeigt eine Messvorrichtung zur Ermittlung von Passerdifferenzen nach Art der Erfindung. Ein auf einem Druckbogen 1 befindliches bildwichtiges Motiv - der Einfachheithalber wieder das nach Figur 1a - wird mit einer Farbvideokamera 2 aufgenommen und ist vergrößert auf einem Farbmonitor 3 darstellbar. Die Farbvideokamera 2 besitzt dabei eine Makrooptik 2.1 mit dem die Bildstelle vergrößert auf das bildwandelnde Element 2.2 abbildbar ist (Figur 2b). Farbvideokamera 2 ist dabei gemäß dem Stand der Technik als Einchip- oder Dreichip-Diodenarray-Kamera ausgeführt. Durch beispielsweise an Makrooptik 2.1 oder am Kamerakörper angebrachte Stützelemente 2.3 ist die Farbvideokamera 2 in definiertem Abstand auf dem Druckbogen 1 positionierbar. Dieser definierte Abstand ergibt ein definiertes Abbildungsverhältnis der Motivstelle auf dem bildwandelndem Element 2.2, somit ein definiertes Abbildingsverhältnis auf dem Farbmonitor 3. Es ist somit bekannt, um wieviel vergrößert eine Skale von 1 mm auf dem Druckbogen auf das bildwandelnde Element 2.2 abgebildet wird. Integriert in das System der Farbvideokamera 2 ist eine Beleuchtungseinrichtung 2.4 nebst zugehöriger Optik mit der die Motivstelle beleuchtbar ist. Die Beleuchtungseinrichtung 2.4 kann beispielsweise ringförmig um Makrooptik 2.1 angeordnet sein, so daß Glanzeffekte bei der Aufnahme von Bildstellen frisch bedruckter Bogen vermieden werden.

Der Farbvideokamera 2 ist ein Signalwandler 2.5 nachgeschaltet, der die Ausgangssignale des bildwandelnden Elementes 2.3 in RGB -Signale umformt und diese insbesondere in digitaler Form bereitstellt. Entsprechend der auf das bildwandelnde Element 2.2 abgebildeten Motivstelle ergibt sich für jeden Bildpunkt (Pixel) ein RGB-Trippel an Werten. Je nach der Zahl der Pixel des bildwandelnden Elementes 2.2 (Zeilen x Spalten) ergeben sich entsprechend viele RGB-Trippel. Werden diese direkt dem Farbmonitor 3 über einen entsprechenden Graphic-Adapter zugeführt, so stellt dieser das vergrößerte Bild der Motivstelle dar.

Damit die Farbvideokamera 2 während des Betrachtens der Motivstelle nicht ständig auf dem Druckbogen 1 verbleiben muß, kann der Farbvideokamera 2 ein Bildspeicher 4 nachgeschaltet sein (Figur 2a). Die Motivstelle wird dann auf dem Farbmonitor 3 in Standbild präsentiert.

Nach Art der Erfindung ist nun vorgesehen, die Bildsignale der Motivstelle, also die Kontur entweder direkt von der Farbvideokamera 2 oder über Bildspeicher 4 einen Farbauszugsrechner 5 zuzuführen, um dort entsprechend den beim Druck verwendeten bzw. in der Motivstelle vorhandenen Druckfarben eine Farbseparation durchzuführen. Der Farbauszugsrechner 5 zerlegt die Bildsignale der Motivstelle wiederum in die Teilbilder der einzelnen Druckfarben, welche dann in Einheiten eines Farbauszugsspeichers 6 abgelegt werden. Farbauszugsspeicher 6 ist dabei in besonderst vorteilhafter Weise als Binaerspeicher ausgebildet, d.h. für jedes Pixel des bildwandelnden Elementes 2.2 ist in jeder Einheit ein Bit vorgesehen und es wird eine Null bspw. bei papierweiß und eine Eins bei entsprechender Druckfarbe in dieses Bit eingeschrieben. In jeder Einheit von Farbauszugsspeicher 6 ist somit lediglich die Verteilung der entsprechenden Druckfarbe auf dem Papier enthalten.

In dem einfachen Beispiel dieser Beschreibung liefert der Farbauszugsrechner 5 zwei Auszüge, entsprechend einem Teilbild für Cyan und einem Teilbild für Magenta. Im Farbauszugsspeicher 6 sind demnach zwei Auszüge in zwei Einheiten zu speichern. Allgemein richtet sich die Zahl der im Farbauszugsspeicher vorzusehenden Einheiten nach der maximalen Zahl der Druckfarben. In Figur 2a sind sechs Einheiten im Farbauszugsspeicher 6 vorgesehen - je einer für die Druckfarben Yellow, Cyan, Magenta, Schwarz B sowie die zwei Sonderfarben S und E.

Die RGB-Signale (digital) seien als Werte zwischen 0 und 100% verstanden. Sie entsprechen Farbwerten in einer "Farbmetrik", die auf den spektralen Durchlasskurven bestimmter Rot-, Grün- und Blaufilter beispielsweise gemäß der PAL-Norm basieren. Trägt man die Farbpunkte in einem dreidimensionalen Koordinatensystem auf, so entsteht ein Farbwürfel, dessen eine Ecke dem Schwarz (R=G=B=0) und die durch die raumdiagonale erreichte andere Ecke dem maximalen Weißpunkt (R=G=B=100%) entspreche. Die übrigen sechs Punkte des Farbwürfels entsprechen den Farben Rot, Grün, Blau, bzw. den Farben Yellow, Cyan, Magenta.

Gemäß der R G B-Signalverteilung, welches der Signalwandler 2.5 liefert entsprechend dem Abbild der Druckbildstelle auf dem bildwandelnden Element 2.2, liegen die R G B-Werte bestimmter Pixel in einem Raumbereich, der einem Yellow, einem Cyan oder einem Magenta entspricht. Die durch Übereinanderdruck entstandenen subtraktiven Farben Blau (Cyan + Magenta), Rot (Yellow + Magenta) und Grün (Cyan + Yellow) sowie Schwarz (Yellow + Cyan + Magenta) nehmen entsprechend die übrigen Raumbereiche ein. Die Unterscheidung, ob Papierweiß oder Schwarz erfolgt durch die Intensität (RGB-Summe). Eine Unterscheidung, ob Schwarz durch Übereinanderdruck oder durch Druckfarbe Schwarz (B) ist ebenfalls möglich, da Übereinanderdruck eher ein Braun also einen anderen RGB-Punkt ergibt als die Druckfarbe Schwarz. Der Farbauszugsrechner 5 prüft nun für jeden Bildpunkt, ob das RGB-Signal von einem Yellow, einem Cyan, einem Magenta oder einem Übereinanderdruck entsprechender Druckfarben stammt und trägt dieses "identifizierte" Pixel in die entsprechende Einheit des Farbauszugsrechners 6 ein.

Liefert ein Pixel beispielsweise ein RGB-Signal, welches von einem Übereinanderdruck der Druckfarben Cyan, Magenta stammt, so wird dieses Pixel an der entsprechenden Bildstelle der Cyan und der Magenta-Einheit des Farbauszugsspeicher 6 eingeschrieben. Wird ein Pixel keiner Druckfarbe oder Druckfarbenkombination eindeutig Zugeordnet, so wird es in allen Einheiten des Farbauszugsspeichers 6 als Papierweiß, also unbedruckt eingeschrieben. Da die Einheiten des Farbauszugsspeichers 6 vorteilhafterweise als Binaerspeicher ausgebildet sind, entsprechen in allen Einheiten von Farbauszugsspeicher 6 Pixel mit Papierweiß beispielsweise einer Null und ein Pixel in einer Einheit einer bestimmten Druckfarbe einer 1. Wie bereits beschrieben, enthält somit jede Einheit vom Farbauszugsspeicher 6 die Verteilung der entsprechenden Drucktarbe auf dem Papierweiß in binaerer Form.

Vorteilhaft gestaltet sich die Farbauszugsrechnung, wenn die RGB-Werte beispielsweise des Bildspeichers 4 zunächst in das HSI-System (Hue, Saturation, Itensity) transformiert werden. In diesem System ergibt sich eine Kreisdarstellung ähnlich wie bei den Farbmaßzahlen nach der DIN 6164 (T:S:D; Buntton, Sättigung, Dunkelstufe).

Im HSI-System liegen die reinen Druckfarben Yellow, Cyan, Magenta in bestimmten Sektoren des sogenannten Bundton-Kreises (Figur 3). Farben des Übereinanderdruckes liegen in bestimmten Sektoren dazwischen. In Figur 3 steht die Achse für die Intensität (I) senkrecht auf der Zeichenebene, der Bunt- bzw. Farbton Hue entspricht einem Winkel und die Sättigung (S) ist durch den Abstand vom Kreismittelpunkt gegeben.

Eine Identifikation der Druckfarben bzw. deren Kombination in Übereinanderdruck mit HSI-Werten ist einfacher, da lediglich der Farbton (Hue) jedes Pixels geprüft werden muß. Lediglich Papierweiß und Schwarz unterscheiden sich zusätzlich durch die Intensität.

Ein weiterer Vorteil des HSI-Systems liegt darin, daß Druckfarben bzw. Übereinanderdrucke bei den üblichen Farbdichtewerten und üblicher Farbannahme stets eine bestimmte Mindestsättigung ergeben. Dies entspricht gemäß Figur 3 einem Mindestabstand (S) vom Kreismittelpunkt.

Eine besonders vorteilhafte Ausführung vom Farbauszugsrechner 5 ergibt sich, wenn dieser dazu ausgebildet ist, erst ab einem bestimmten Mindestsättigungswert und/oder in Kombination mit der Intensität ein Pixel einer bestimmten Druckfarbe/Druckfarbenkombination zuzuordnen. Die Wirkung von Farbauszugsrechner 5 ist dann einem Schwellwert-Farbfilter vergleichbar, welches eine Farbe erst ab einer bestimmten Intensität und Helligkeit durchläßt.

Der Farbauszugsrechner 5 steht in Verbindung mit einem Farbwertespeicher 5.1 in dem beispielsweise die HSI-Werte der Normdruckfarben (z.B. Europaskala) einzeln und im Übereinanderdruck bei Standartdichten auf Normalweißpapier abgelegt sind (Figur 2a). Zusätzlich ist es aber sinnvoll, vor der eigentlichen Messung eine Eichmessung beispielsweise auf den Volltonfeldern einer auf dem Druckbogen befindlichen Farbkontrollleiste 1.1 durchzuführen. Dabei wird die Farbvideokamera 2 nacheinander auf die Volltonfelder Yellow, Cyan, Magenta, Schwarz, deren Übereinanderdruck sowie der Sonderfarben gesetzt und die RGB- bzw. HSI-Werte in Form von Farbraumbereichen gespeichert. Ferner erfolgt eine Eichung für Papierweiß.

Mit diesen durch die Eichung aktualisierten Farbwerten ist mittels dem Farbauszugsrechner 5 eine genaue Farbseparation möglich d.h. ein Zerlegen der vergrößerten Motivstelle in Druckfarbenauszügen und entsprechendes Ablegen im Farbauszugsspeicher 6. Falls aus den RGB- bzw. HSI-Werten bestimmte Pixel keine eindeutige Zuordnung zu einer Druckfarbe ergeben (z.B. durch farbige Faserflecken des Papiers), so können diese Pixel beispielsweise als unbedruckt interpretiert, soll heißen dem Papierweiß zugeordnet werden.

Auch ist es sinnvoll, vor jeder Messung den Abbildungsmeßstab der Farbvideokamera 2 zusätzlich durch eine Eichmessung zu bestimmen, indem die Farbvideokamera 2 auf ein bestimmtes Eichfeld gesetzt wird, welches beispielsweise 2 Eichstriche mit bekannten Abstand aufweist. Durch diese Eichmessung wird somit bestimmt, wieviele Zeilen und/oder Spalten des bildwandelnden Elementes 2.2 zwischen den Eichstrichen liegen. Diese Eichmessung wird dann für die Umrechnung der Passerdifferenzen in mm verwendet.

Die einzelnen im Farbauszugsspeicher 6 abgespeicherten Farbauszüge sind einem Bildrechner 7 zuführbar, über welchen diese einzeln oder gemeinsam auf dem Farbmonitor 3 darstellbar sind. Da die Einheiten des Farbauszugsspeichers 6 als Binärspeicher ausgebildet sind, erfolgt eine Darstellung beispielsweise des Cyanteilbildes auf Farbmonitor 3 in einem einheitlichen Cyan. Entsprechend erfolgt die Darstellung von papierweiß ebenfalls in einem Standardweiß. Die Einheiten des Farbauszugsspeicher 6 benötigen somit lediglich eine einzelne Speicherzelle, in welcher eine Information über die Farbe des in der Einheit enthaltenen Auszuges abgelegt ist.

An Bildrechner 7 ist eine Tastatur 8 und/oder ein Bedienelement 9 (Maus, Joy-Stick, Rollball o.ä.) angeschlossen, mit dem der Drucker auswählen kann, welchen Auszug er einzeln betrachten möchte. Ferner können mehrere frei auswählbare Auszüge auch übereinander gelegt werden, ohne daß die subtraktiven Farben, welche sich bei dem Übereinanderdruck ergeben, dargestellt werden. Auch kann die Reihenfolge dieses Übereinanderlegens der Auszüge frei wählbar sein. Somit ist diejenige Farbreihenfolge wählbar, bei der sich die beste Erkennbarkeit der Passerdifferenzen einer Kontur ergeben.

Durch die Hauptkomponenten Farbauszugsrechner 5, Farbauszugsrechner 6 und Bildrechner 7 ist somit das Bild von der Farbvideokamera 2 einer Motivstelle entweder direkt in natura oder in einzelnen oder mehreren Auszügen darstellbar. Diese Hauptkomponenten stellen bereits eine komfortable Einrichtung für die visuelle Beurteilung eines Passers an Konturen aufweisenden Bildstellen im Druckbild dar. Der erfahrene Drucker kann mit diesem Hilfsmittel bereits die Passerdifferenzen beurteilen und entsprechende vorzunehmende Einstellungen schätzen. Selbstverständlich können mit diesem bisher beschriebenen System auch die üblichen Passmarken/Passzeichen aufgenommen und entweder lediglich vergrößert oder in Auszügen aufbereitet dargestellt werden. Auch hier bietet das bisher beschriebene Prinzip der Darstellung in Auszügen erhebliche Vorteile in der Passerbeurteilung.

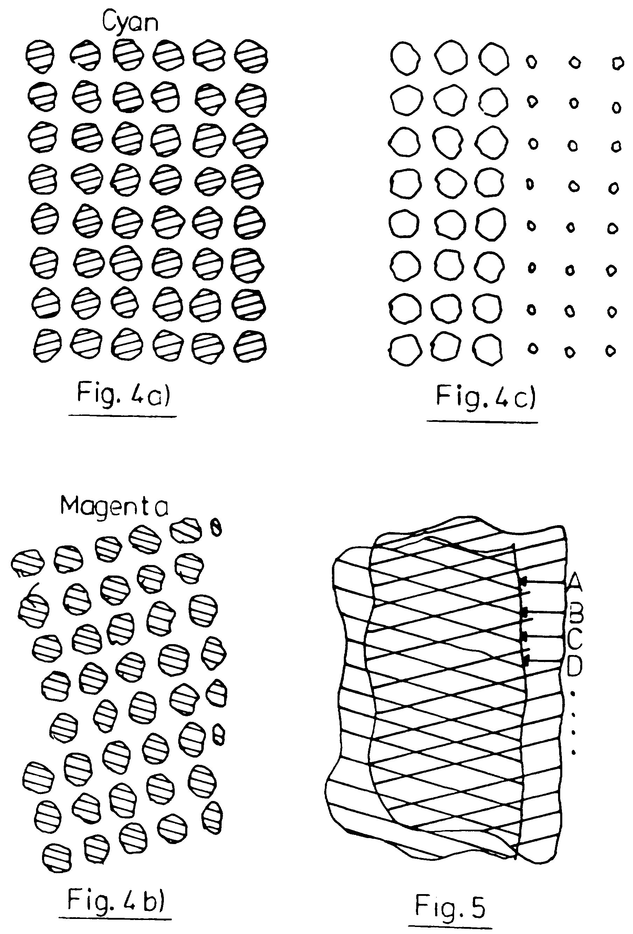

Erfindungsgemäß ist weiterhin vorgesehen, im Bildrechner 7 in jedem Auszug (Teilbild) eine Rasterpunktseparation vorzunehmen. Dies bedeutet, daß Rasterpunkte unterhalb einer bestimmten Größe aus dem einzelnen Auszug wegeliminiert, also dem papierweiß zugeordnet werden. Dies ist insbesondere dann nötig, wenn - entgegen dem bisherigen Beispiel - in einem oder mehreren Teilbildern der Kontur diese lediglich durch einen deutlichen Sprung in der Rasterpunktgröße gebildet ist. In dem anfangs gewählten einfachen Beispiel des Buchstaben "P" als unbedruckter Bereich (papierweiß) mit blauer Umgebung (Übereinanderdruck Cyan und Magenta) würde dies einem hellblauen "P" in dunkelblauer Umgebung entsprechen. Der Helligkeitssprung (Helligkeitskontur) entsteht dann durch den erwähnten Sprung der Rasterpunktgröße (Figur 4.c). Auf dem Farbmonitor 3 sind diese modifizierten Auszüge ebenfalls - auswählbar über Tastatur 8 und/oder Bedienelement 9 - jeweils einzeln oder in frei wählbarer Reihenfolge übereinanderliegend darstellbar.

Nach der Erfindung ist nun vorgesehen, aus dem Versatz der Konturen der einzelnen Auszüge bzw. der modifizierten Auszüge (Rasterpunktefilterung) die Passerdifferenz zu bestimmen. Nach dem beispielgemäß Figur 1c bzw. Figur 4a und b also aus dem Versatz der Cyanauszug-Kontur gegenüber der Magentaauszug-Kontur.

Damit der Versatz der Konturen in den einzelnen Auszügen zueinander errechnet werden kann, ist der Bildrechner 7 dazu ausgebildet in jedem Auszug eine Grenzlinie zwischen dem Bereich mit Rasterpunkten und dem Bereich ohne Rasterpunkten zu bilden (Fig. 5). Aus dem Versatz dieser Grenzlinien beispielsweise in zwei Auszügen zueinander, erfolgt dann die Errechnung der Passerdifferenz eines Teilbildes gegenüber einem zweiten.

Besonders einfach gestaltet sich diese Rechnung, wenn die Kontur (z.B. Buchstabe in Negativschrift) durch den Übereinanderdruck zweier Teilbilder in Vollton entstanden ist. Die Grenzlinie in jedem Auszug entspricht dann einfach der Grenze zwischen dem Bereich Vollton und Bereich papierweiß. Da wegen der starken Vergrößerung und der Papierrauheit diese Grenze i.A. einen stark zerrissenen Zerlauf zeigt, kann diese rechnerisch geglättet werden, beispielsweise durch eine Interpolation.

Die Berechnung von Passerdifferenzen, d.h. von Abstandsvektoren, welche dem Versatz der Konturen (Grenzlinien in den Teilbildern) zueinander entsprechen, kann dann über eine Mittelung über mehrere Einzelberechnungen erfolgen (A, B, C, D, ... in Figur 5). Die zuletzt beschriebene Bestimmung von Passerdifferenzen kann selbstverständlich auch an den Konturen von Passmarken insbesondere Passkreuzen erfolgen.

Handelt es sich um eine Kontur, welche in dem wie eingangs beschriebenen einfachen Beispiel durch den Übereinanderdruck von wenigstens zwei Teilbildern mit Rasterpunkten entstanden ist, so kann im Bildrechner 7 in jedem Auszug der Bereich mit Rasterpunkten zu einer Volltonfläche ergänzt bzw. aufgefüllt werden (Fig. 5). Erreichen läßt sich dies, indem die Pixel mit Papierweiß zwischen den Rasterpunkten der entsprechenden Auszugsfarbe zugeordnet werden. Die Errechnung bzw. Bildung von Grenzlinien in den Auszügen, welche dann den Konturen in den Teilbildern entsprechen, erfolgt dann wie zuletzt bei den durch Volltonflächen gebildeten Konturen, gleiches gilt dann für die Errechnung der Passerdifferenz aus dem Versatz der Konturen in den einzelnen Auszügen zueinander. Wegen des bekannten Abbildungsmeßstabes (Beispiel Eichmessung) erfolgt dann durch Bildrechner 7 die Errechnung der Passerdifferenz in mm.

Anstatt der Bestimmung der Passerdifferenzen aus dem Versatz der Grenzlinien in den Teilbildern zueinander, kann die Passerdifferenz zwischen zwei Teilbildern auch aus dem Extremum einer Korrelationsrechnung bestimmt werden. Dazu wird aus den Bildinhalten zweier Auszüge (Teilbilder) eine Kreuzkorrelationsfunktion gebildet. Wenn AC (S, Z) der Bildinhalt bspw. Cyan-Auszuges ist, wobei S die Spaltenzahl, Z die Zeilenzahl der Bildpunkte (Pixel) des im Farbauszugsspeicher 6 abgespeicherten Auszuges entsprechen, demzufolge AM (S, Z) der Bildinhalt der Magenta-Auszuges darstellt, so ist die Kreuzkorrelation, wie aus der Mathematik bekannt, wie folgt definiert:

$$CM\ (x,\ y) = \int_{-S,\ -Z}^{+S,\ +Z} AC\ (s,\ z) \cdot AM\ (s+x,\ z+y)\ dS + dZ$$

S bzw. Z ist dabei die maximale Spalten- bzw. Zeilenzahl des bildwandelnden Elementes 2.2, also die entsprechende maximale Zahl der Bildpunkte (Pixel) in einer Bildzeile bzw. Bildspalte. Der Wert x., y. bei dem CM (x, y) sein globales Extremum (Maximum) annimmt ergibt somit den Verschiebungsvektor mit dem die Magenta-Kontur (Auszug) gegenüber der Cyan-Kontur versetzt ist.

Der x., y.-Wert des Verschiebungsvektors muß dann nur noch genau dem Abbildungsmaßstab der Farbvideokamera umgerechnet werden und ergibt dann den Passerdifferenzvektor bspw. in der Einheit mm.

Die Berechnung der Kreuzkorrelationsfunktion läßt sich auf eine Dimension reduzieren, d.h. die Integration erstreckt sich nur über die Spalten bzw. Zeilenrichtung, wenn die Kontur der Bildstelle senkrecht zur Spalten- bzw. Zeilenrichtung verläuft. Nach Fig. 1c) verläuft die Richtung der Kontur senkrecht zur Richtung der Bildzeilen - die Integration erfolgt somit in jeder Bildzeile über die Spaltenrichtung, d.h. quer zur Kontur.

Mit dem bisher beschriebenen Verfahren und den entsprechenden Vorrichtungselementen lassen sich Passerdifferenzen im Bild des Druckbogens an mehreren Konturen aufweisenden Druckbildstellen bestimmen. Um aus diesen Passerdifferenzen der entsprechenden Teilbilder zueinander die nötigen Registerverstellungen zu bestimmen, ist es nun nur noch nötig, die X-, Y-Koordinaten jeder Messtelle, d.h. der Druckbildstelle auf dem Druckbogen zu bestimmen. Dazu wird der Druckbogen, wie bei der Farbabrüstung möglich auf eine flache Unterlage gelegt und mit den Kanten einer Druckbogenecke in einen Anschlag positioniert. Eine derartige Positionierung eines Druckbogens auf einer Unterlage ist bei Farbabstimmpulten mit traversierenden Farbdichtemessköpfen Stand der Technik. Zur Bestimmung der X-, Y-Koordinaten der Messtellen kann die Farbvideokamera 2 mechanisch über den Druckbogen geführt sein, beispielsweise ähnlich wie der Zeichenstift eines Zeichenplotters. Durch in den Führungselementen angebrachte Positionsgeber erfolgt dann die Bestimmung der X-, Y-Koordinaten der Meßstelle auf den Druckbogen. Auch eine Führung in der Art eines Mehrgelenks ist denkbar. Die Bestimmung der Position der Farbvideokamera 2 auf dem Druckbogen erfolgt dann durch in den Drehgelenken des Mehrgelenks angebrachte Drehwinkelgeber.

Die X-, Y-Koordinaten der Messtellen sowie die in diesen durch den Bildrechner 7 errechneten Passerdifferenzen der einzelnen Teilbilder zueinander können dann einen Registerrechner 10 zugeführt werden, der aus diesen Werten nötige Verstellungen für das Seiten-, Umfangs- und Diagonalregister in den einzelnen Druckwerken errechnet und in einer weiteren Ausgestaltung auch in Form von Steuerbefehlen an Registerverstelleinrichtungen dieser Druckwerke weiterleitet. Dies ist in Figur 2a) durch die Pfeile bei Registerrechner 10 angedeutet.

Werden Passerdifferenzen an mehreren Bildstellen ermittelt, so können Bildstellen mit verschiedenen Gewichtsfaktoren versehen werden und der Registerrechner 10 aus den entsprechenden Passerdifferenzen eine für alle Messtellen optimale Registerverstellung errechnen. Dies ist insbesondere dann von Vorteil, wenn, wie häufig an Mehrfarbenoffsetdruckprodukten feststellbar, Passerdifferenzen im Bild nicht gleichförmig über den Bogen verteilt sind, sondern vielmehr bestimmte Stellen mehr oder weniger passen, andere wiederum Passerdifferenzen zeigen. Registerverstellungen können dann nur als ein optimaler Kompromiß vorgenommen werden.

Bezugszeichenliste

| | |
|---|---|
| 1 | Druckbogen |
| 1.1 | Farbkontrollstreifen |
| 2 | Farbvideokamera |
| 2.1 | Makrooptik |
| 2.2 | bildwandelndes Element |
| 2.3 | Stützelement |
| 2.4 | Beleuchtungseinrichtung |
| 2.5 | Signalwandler |
| 3 | Farbmonitor |
| 4 | Bildspeicher |
| 5 | Farbauszugsrechner |
| 5.1 | Farbwertspeicher |
| 6 | Farbauszugsspeicher |
| 7 | Bildrechner |
| 8 | Tastatur |
| 9 | Bedienelement |
| 10 | Registerrechner |

**Patentansprüche**

**1.** Verfahren zur Bestimmung von Passerdifferenzen an Druckbildstellen eines Mehrfarbenoffsetdruckes, bei welchem eine Druckbildstelle mittels einer Farbvideokamera vergrößert erfaßt wird, wobei eine Druckbildstelle erfaßt wird, welche eine Kontur aufweist, die durch den übereinanderdruck von wenigstens zwei verschiedenen Druckfarben entstanden ist und als Helligkeits- und/oder Farbunterschied erkennbar ist, daß Bild dieser Druckbildstelle aus dem Farbenraum der Farbvideokamera in den Farbenraum der beim Druck verwendeten Druckfarben gewandelt und somit in diese Farbauszüge zerlegt wird und die Bestimmung der Passerdifferenzen aus einer Ermittlung des Versatzes der Konturen in den einzelnen Farbauszügen relativ zueinander erfolgt.

**2.** Verfahren nach Anspruch 1, bei welchem die Zerlegung der Druckbildstelle in Farbauszüge im RGB-Farbenraum der Farbvideokamera (2) erfolgt.

**3.** Verfahren nach Anspruch 1, bei welchem die Zerlegung der Druckbildstelle in Farbauszüge im HSI-Farbsystem erfolgt.

**4.** Verfahren nach Anspruch 2 oder 3, bei welchem in jedem Farbauszug Rasterpunkte unterhalb einer bestimmten Rasterpunktgröße eliminiert werden.

**5.** Verfahren nach einem der vorhergehenden Ansprüche, bei welchen in jedem Farbauszug Bereiche mit Rasterpunkten oberhalb einer bestimmten Rasterpunktgröße zu einer Volltonfläche aufgefüllt werden und eine Grenzlinie zum übrigen Bildbereich im jeweiligen Farbauszug gebildet wird.

**6.** Verfahren nach einem der vorhergehenden Ansprüche, bei welchen in jedem Farbauszug eine Grenzlinie gebildet wird, die einen Bereich mit Rasterpunkten oberhalb einer bestimmten Rasterpunktgröße von den übrigen Bildbereichen des Farbauszuges trennt.

7. Verfahren nach Anspruch 5 oder 6, bei welchem die Passerdifferenz durch Berechnung von Abstandsvektoren der Grenzlinien in den verschiedenen Farbauszügen zueinander erfolgt.

8. Verfahren nach Anspruch 5 oder 6, bei welchen die Passerdifferenzbestimmung durch Ermittlung der nötigen Verschiebung der dem beim Druck verwendeten Druckfarben entsprechenden Farbauszüge gegeneinander erfolgt, bis die Grenzlinie in den einzelnen Farbauszügen miteinander korrelieren.

9. Verfahren nach einem der Ansprüche 1 bis 4, bei welchen die Passerdifferenz aus einem Extremum einer Korrelationsrechnung der Bildinhalte der einzelnen Farbauszüge zueinander bestimmt wird.

10. Vorrichtung zur Durchführung des Verfahrens gemäß einem der Ansprüche 1 bis 9, mit einer Farbvideokamera (2) zur Erfassung einer Druckbildstelle, einer nachgeschalteten Bildverarbeitungseinrichtung (5 - 7), sowie einem Farbmonitor (3) zur vergrößerten Darstellung der Druckbildstelle, wobei die Bildverarbeitungseinrichtung (5-7) einen Farbauszugsrechner (5) aufweist, mit dem eine Druckbildstelle, welche ein Kontur aufweist und aus dem Übereinanderdruck wenigstens zwei Druckfarben entstanden ist aus dem Farbenraum der Videokamera (2) in den durch die beim Druck verwendeten Druckfarben gebildeten Farbraum transformierbar und in die entsprechende Farbausüge zerlegbar ist, und die Bildverarbeitungseinrichtung (5-7) einen Farbauszugsspeicher (6) aufweist, in dessen Einheiten die den Teilbildern entsprechenden Farbauszüge abspeicherbar sind und die Bildverarbeitungseinrichtung (5-7) einen Bildrechner (7) aufweist, der dazu ausgebildet ist, die Verschiebung der einzelnen Konturen in den den Teilbildern entsprechenden Farbauszügen zu errechnen und daraus die Passerdifferenz zu bestimmen.

11. Vorrichtung nach Anspruch 10, bei welcher der Farbvideokamera (2) ein Signalwandler (2.5) nachgeschaltet ist, durch den das die Bildinformation der Druckbildstelle tragende Signal in Form von digitalen RGB- oder HSI-Werten entnehmbar ist.

12. Vorrichtung nach Anspruch 10 oder 11, bei welcher ein Bildspeicher (4) vorgesehen ist, in dem das Bild der Druckbildstelle abspeicherbar ist.

13. Vorrichtung nach Anspruch 11 oder 12, bei welcher ein Farbwertspeicher (5.1) vorgesehen ist, in dem die RGB- bzw. HSI-Werte der beim Druck verwendeten Druckfarben abspeicherbar sind.

14. Vorrichtung nach Anspruch 11, bei welcher im Farbwertspeicher (5.1) die RGB- oder HSI-Werte der Druckfarben einzeln und im Übereinanderdruck, ermittelt durch eine Eichmessung mit Farbvideokamera (2) an einer mitgedruckten Farbkontrolleiste (1.1), abspeicherbar sind.

15. Vorrichtung nach einem der vorhergehenden Ansprüche, bei welcher eine Tastatur (8) und/oder ein Bedienelement (9) vorgesehen ist, mit dem über Bildrechner (7) am Farbmonitor (3) die Druckbildstelle in einzelnen, beliebig wählbaren oder übereinandergelegt in beliebig wählbarer Reihenfolge als Farbauszüge darstellbar sind.

16. Vorrichtung nach einem der vorhergehenden Ansprüche, bei welcher die Farbvideokamera (2) als Einchip- oder Dreichip-Diodenarray-Kamera ausgebildet ist.

17. Vorrichtung nach einem der vorhergehenden Ansprüche, bei welcher die Farbvideokamera (2) Beleuchtungseinrichtungen (2.4) zur Ausleuchtung der Druckbildstelle aufweist und über Stützelemente (2.3) in einem zu einer definierten Vergrößerung der Druckbildstelle auf Farbmonitor (3) führenden Abstand auf dem Druckbogen (1) positionierbar ist.

18. Vorrichtung nach einem der vorhergehenden Ansprüche, bei welcher Mittel vorgesehen sind, mit denen die Koordinaten der von der Farbvideokamera (2) erfaßten Druckbildstelle auf dem Druckbogen (1) feststellbar sind, bei welcher ein Registerrechner (10) vorgesehen ist, dem diese Koordinaten der Druckbildstelle sowie die im Bildrechner (7) daraus ermittelten Passerdifferenzen zuführbar sind und der Registerrechner (10) dazu ausgebildet ist, aus den Koordinaten der Druckbildstellen nebst den Passerdifferenzen Registerverstellungen zu errechnen, wobei diese auf Farbmonitor (3) darstellbar und/oder direkt in Form von Steuerdaten den Registerstelleinrichtungen in den einzelnen Druckwerken zuführbar sind.

## Claims

1. Process for determining matching differences at printed image positions of a multi-colour offset print, in which a printed image position is viewed enlarged by means of a colour video camera, whereby a printed image position is sensed which has a contour which has arisen by the superimposed printing of at least two different printing inks and which is evident as a brightness and/or colour difference, the image of this printed image position is converted from the colour space of the colour video camera into the colour space of the printing inks used in the print and accordingly is broken down into these colour separations and the determination of the matching differences takes place from a determination of the offset of the contours in the individual colour separations relative to one another.

2. Process according to Claim 1, in which the breakdown of the printed image position into colour separations takes place in the RGB colour space of the colour video camera (2).

3. Process according to Claim 1, in which the breakdown of the printed image position into colour separation takes place in the HSI colour system.

4. Process according to Claim 2 or 3, in which in each colour separation, raster points below a given raster point size are eliminated.

5. Process according to one of the preceding Claims, in which in each colour separation regions with raster points above a given raster point size are filled in to a full tone surface and a boundary line relative to the remaining image area is formed in the respective colour separation.

6. Process according to one of the preceding Claims, in which in each colour separation a boundary line is formed which separates a region with raster points above a given raster point size from the remaining image areas of the colour separation.

7. Process according to Claim 5 or 6, in which the register difference results by calculation of displacement factors of the boundary lines in the different colour separations relative to one another.

8. Process according to Claim 5 or 6, in which the register difference determination takes place by working out the necessary displacement of the colour separations corresponding to the printing inks used in the print relative to one another, until the boundary lines in the individual colour separations correlate with one another.

9. Process according to one of Claims 1 to 4, in which the register difference is determined from an extreme value of a correlation calculation of the image contents of the individual colour separations relative to one another.

10. Device for carrying out the process in accordance with one of Claims 1 to 9 with a colour video camera (2) for capturing a printed image position, a subsequently connected image processing unit (5-7) as well as a colour monitor (3) for the enlarged representation of the printed image position, wherein the colour processing unit (5-7) has a colour separation calculator (5) with which a printed image position, which has a contour and which has arisen from the superimposed printing of at least two printing inks can be transformed from the colour space of the video camera (2) into the colour space constituted by the printing inks used in the printing and can be broken down into the corresponding colour separations, and the image processing unit (5-7) has a colour separation store (6) in the units of which the colour separations corresponding to the partial images can be stored and the image processing unit (5-7) has an image calculator (7) which is constructed to calculate the displacement of the individual contours in the colour separations corresponding to the partial images and to determine the register difference therefrom.

11. Device according to Claim 10, in which the colour video camera (2) has connected to it a signal convertor (2.5) by which the signal carrying the image information of the printed image position can be extracted in the form of digital RGB or HSI values.

12. Device according to Claim 10 or 11, in which an image store (4) is provided in which the image of the printed image position is storable.

13. Device according to Claim 11 or 12, in which a colour value store (5.1) is provided in which the RGB or HSI values of the printing inks used in the print are storable.

14. Device according to Claim 11, in which in the colour value store (5.1) the RGB or HSI values of the printing inks are storable individually and in superimposed printing, determined by a calibration measurement with the colour video camera (2) on a colour control strip (1.1) printed at the same time.

15. Device according to one of the preceding Claims, in which a keyboard (8) and/or an interface element (9) is provided with which via image convertor (7) on the ink monitor (3), the printed image position is displayable as colour separations individually chosen as desired or superimposed in sequence chosen as desired.

16. Device according to one of the preceding Claims, in which the colour video camera (2) is constructed as a single chip or three chip diode array camera.

17. Device according to one of the preceding Claims, in which the colour video camera (2) has illumination devices (2.4) for illuminating the printed image position and is positionable by means of support elements (2.3) at a distance above the printed sheet (1) leading to a defined enlargement of the printed image position on the colour monitor (3).

18. Device according to one of the preceding Claims, in which means are provided with which the coordinates of the printed image position captured by the colour video camera (2) are determined on the printed sheet (1), in which a register calculator (10) is provided to which these coordinates of the printed image position as well as the register differences determined therefrom in the image calculator (7) can be fed and the register calculator (10) is constructed in order to calculate from the coordinates of the printed image position together with the register differences register adjustments, wherein these can be shown on the colour monitor (3) and/or can be fed directly in the form of control data to the register adjustment devices in the individual printing units.

## Revendications

1. Procédé pour déterminer des différences de repérage de positions d'image d'une impression offset en plusieurs couleurs, dans lequel une position d'image d'impression est détectée de façon agrandie au moyen d'une caméra vidéo couleur, une position d'image d'impression étant détectée, laquelle présente un contour qui est formé par la superposition d'au moins deux encres d'impression différentes et peut être reconnu comme différence d'intensité et/ou différence de couleur, l'image de cette position d'image d'impression passant de l'espace des couleurs de la caméra vidéo couleur dans l'espace des couleurs des encres d'impression utilisées lors de l'impression et, ainsi, étant décomposée en ces couleurs séparées et la détermination des différences de repérage étant effectuée, de façon relative, à partir d'une détection du décalage des contours dans les couleurs séparées individuelles.

2. Procédé selon la revendication 1, dans lequel la décomposition de la position d'image d'impression en couleurs séparées est effectuée dans l'espace des couleurs rouge-vert-bleu (RGB) dc la caméra vidéo couleur (2).

3. Procédé selon la revendication 1, dans lequel la décomposition de la position d'image d'impression en couleurs séparées est effectuée dans le système de couleur teinte-saturation-intensité (HSI).

4. Procédé selon la revendication 2 ou 3, dans lequel, dans chaque couleur séparée, des points de trame au-dessous d'une taille déterminée sont éliminés.

5. Procédé selon une des revendications précédentes, dans lequel, dans chaque couleur séparée, des zones ayant des points de trame au-dessus d'une taille déterminée sont remplies en une surface de teinte homogène et une ligne de séparation par rapport à la zone d'image restante est formée dans la couleur séparée respective.

6. Procédé selon une des revendications précédentes, dans lequel, dans chaque couleur séparée, il est formé une ligne de séparation qui sépare une zone ayant des points de trame au-dessus d'une taille déterminée des zones d'image restantes de la couleur séparée.

7. Procédé selon la revendication 5 ou 6, dans lequel les différences de repérage sont effectuées, de façon relative, dans les différentes couleurs séparées par calcul des vecteurs d'écartement des lignes de séparation.

8. Procédé selon la revendication 5 ou 6, dans lequel la détermination des différences de repérage est effectuée mutuellement par détection du déplacement nécessaire des couleurs séparées correspondant aux encres utilisées lors de l'impression, jusqu'à corréler ensemble les lignes de séparation dans les couleurs séparées individuelles.

**9.** Procédé selon une des revendications 1 à 4, dans lequel les différences de repérage sont déterminées l'une par rapport à l'autre à partir d'un extremum d'un calcul de corrélation des contenus d'image des couleurs séparées individuelles.

**10.** Dispositif pour la mise on oeuvre du procédé selon une des revendications 1 à 9, comportant une caméra vidéo couleur (2) pour détecter une position d'image d'impression, un dispositif de traitement d'image (5-7) disposé en aval, ainsi qu'un moniteur (3) pour la représentation agrandie de la position d'image d'impression, le dispositif de traitement d'image (5-7) présentant un calculateur de séparation des couleurs (5), grâce auquel une position d'image d'impression, laquelle présente un contour et est formée de la superpostion d'au moins deux encres d'impression, peut être transformée de l'espace des couleurs de la caméra vidéo (2) dans l'espace des couleurs formé par les encres utilisées lors de l'impression et être décomposée dans les couleurs séparées correspondantes, et le dispositif de traitement d'image (5-7) présentant une mémoire d'images séparées (6) dans les unités de laquelle les couleurs séparées correspondant aux images partielles peuvent être stockées, et le dispositif de traitement d'image (5-7) présentant un calculateur d'image (7) adapté pour calculer le déplacement des contours individuels dans les couleurs séparées correspondant aux images partielles et, à partir de cela, déterminer les différences de repérage.

**11.** Dispositif selon la revendication 10, dans lequel la caméra vidéo couleur (2) est disposée en amont d'un convertisseur de signaux (2.5) grâce auquel le signal portant l'information d'image de la position d'image d'impression peut être extrait sous forme de valeurs numériques rouge-vert-bleu (RGB) ou teinte-saturation intensité (HSI).

**12.** Dispositif selon la revendication 10 ou 11, dans lequel une mémoire d'image (4) est prévue, dans laquelle l'image de la position d'image d'impression peut être stockée.

**13.** Dispositif selon la revendication 11 ou 12, dans lequel une mémoire de valeur chromatique (5.1) est prévue, dans laquelle les valeurs rouge-vert-bleu (RGB) ou teinte-saturation-intensité (HSI) des encres utilisées lors de l'impression peuvent être stockées.

**14.** Dispositif selon la revendication 11, dans lequel, dans la mémoire de valeur chromatique (5.1), les valeurs rouge-vert-bleu (RGB) ou teinte-saturation-intensité (HSI) des encres d'impression peuvent être stockées, individuellement et en superposition, en étant détectées par un étalonnage par la caméra vidéo couleur (2) sur une barrette de contrôle de couleur (1.1) également imprimée.

**15.** Dispositif selon une des revendications précédentes, dans lequel un clavier (8) et/ou un élément de manipulation (9) sont prévus grâce auxquels, par l'intermédiaire du calculateur d'image (7), les positions d'image d'impression peuvent être représentées comme couleurs séparées sur le moniteur (3) en successions individuelles, pouvant être choisies de façon quelconque ou, de façon superposée, en une succession pouvant être choisie de façon quelconque.

**16.** Dispositif selon une des revendications précédentes, dans lequel la caméra vidéo couleur (2) est réalisée sous forme d'une caméra à rangées de diodes à une puce ou à trois puces.

**17.** Dispositif selon une des revendications précédentes, dans lequel la caméra vidéo couleur (2) présente des dispositifs d'éclairage (2.4) pour éclairer la position d'image d'impression et peut être positionnée, par l'intermédiaire d'éléments d'appui (2.3), sur la feuille d'impression (1) à un écartement entraînant un grossissement défini de la position d'image d'impression sur le moniteur (3).

**18.** Dispositif selon une des revendications précédentes, dans lequel sont prévus des moyens grâce auxquels les coordonnées de la position d'image d'impression détectée par la caméra vidéo couleur (2) peuvent être déterminées sur la feuille d'impression (1), dans lequel il est prévu un calculateur de repérage (10) auquel ces coordonnées de la position d'image d'impression ainsi que les différences de repérage détectées ainsi dans le calculateur d'image (7) peuvent être amenées, et le calculateur de repérage (10) est réalisé de façon à calculer à partir des coordonnées des positions d'image d'impression à côté des différences de repérage des réglages de repérage, ceux-ci pouvant être représentés sur le moniteur (3) et/ou amenés directement sous la forme de données de commande aux dispositifs de réglage de repérage dans les unités d'impression individuelles.

Fig.1 a)

Fig. 1b)

Cyan

Magenta

Fig. 1c)

2,5
4
5,1
2
1,1
5
1
6
Y
C
M
B
S
E
10
7
3
Fig. 2a)
8
9

2.5
2.2
2
2.1
2.3
2.4
2.4
1
Fig. 2b)

C+Y
Green
S
Y
Hue
Y
+
M
Red
C
M
Blue
C+M
Fig.3

Cyan

Fig. 4a)

Fig. 4c)

Magenta

Fig. 4b)

A
B
C
D

Fig. 5